# EUROPÄISCHE PATENTSCHRIFT

(11) **EP 0 801 884 B1**
(45) Veröffentlichungstag und Bekanntmachung des Hinweises auf die Patenterteilung: **12.05.1999**
(21) Anmeldenummer: 96924758.4
(22) Anmeldetag: 20.07.1996
(51) Int. Cl.: H05K 9/00

(54) **BAUGRUPPENTRÄGER FÜR EIN ELEKTRONISCHES STEUERGERÄT MIT SIGNALVERARBEITENDEN BAUELEMENTEN UND SCHNELL ARBEITENDEN DIGITALEN BAUELEMENTEN**
MODULE MOUNTING RACK FOR AN ELECTRONIC CONTROL UNIT WITH SIGNAL-PROCESSING COMPONENTS AND RAPID-OPERATION DIGITAL COMPONENTS
SUPPORT DE BLOCS DE COMPOSANTS POUR APPAREIL DE COMMANDE ELECTRONIQUE COMPORTANT DES COMPOSANTS DE TRAITEMENT DE SIGNAUX ET DES COMPOSANTS NUMERIQUES RAPIDES

(30) Priorität: 02.10.1995 DE 19536848
(43) Veröffentlichungstag der Anmeldung: 22.10.1997
(73) Patentinhaber: ROBERT BOSCH GMBH, 70442 Stuttgart (DE)
(72) Erfinder: ROOZENBEEK, Herman, D-71701 Schwieberdingen (DE); TEPASS, Bernd, D-74360 Ilsfeld (DE)
(86) Internationale Anmeldenummer: DE9601334
(87) Internationale Veröffentlichungsnummer: WO9713395

(56) Entgegenhaltungen:
- EP-A- 0 429 695
- EP-A- 0 639 940
- DE-A- 3 811 079
- US-A- 5 023 753
- ELECTRONIQUE RADIO PLANS, Nr. 510, 1.Mai 1990, Seiten 59-67, XP000160588 BROKAW P ET AL: "PROBLEMES DE MASSE ET TECHNIQUES DE DECOUPLAGE EN HAUTES ET BASSES FREQUENCES"

## Beschreibung

### Stand der Technik

Die Erfindung geht von einem Baugruppenträger für ein elektronisches Steuergerät mit signalverarbeitenden analogen und/oder digitalen Bauelementen und schnell arbeitenden digitalen Bauelementen nach der im Oberbegriff des Anspruchs 1 angegebenen Gattung aus. Die schnell arbeitenden digitalen Bauelemente unterscheiden sich von den signalverarbeitenden digitalen Bauelemente durch die Arbeitsfrequenz und damit verbundene Rückwirkungen auf die elektrischen Eigenschaften im Bereich der Strom- und Spannungszufuhr bzw. der Strom und Spannungsableitung. Zu den "schnell" arbeitenden digitalen Bauelementen sind außer dem Mikroprozessor und dem Mikrokontroller alle digitalen Bauelemente zu zählen, die zum Bussystem gehören und mit mindestens einer der Adress-, Daten-, Bussteuer-, oder Chipselectleitungen eines Mikroprozessors oder Mikrokontrollers, wie z.B. EPROM, RAM und Adresslatch, verbunden sind und Daten mit Frequenzen, die größer als ein Megahertz sind, übertragen.

Ein solcher Baugruppenträger weist außer den signalverarbeitenden und den schnell arbeitenden digitalen Bauelementen auch Bauelemente mit sowohl schnell arbeitenden digitalen Funktionsteilen als auch signalverarbeitenden Funktionsteilen sowie Leistungsbauelemente auf, die auf dem Baugruppenträger, der z.B. eine Leiterplatte sein kann, zusammen mit den gedruckten Verbindungen für Spannungsversorgung und Masse sowie Anschlußkontakten für Signalleitung, Schirm und Masseleitung angeordnet sind. Dabei können die gedruckten Verbindungen auch in mehreren, übereinander angeordneten Ebenen ausgeführt sein. Zur Vermeidung eines störenden Potentialgefälles in den Masseleitungen, das die Funktion einzelner Bauelemente beeinträchtigen kann, hat es sich als vorteilhaft erwiesen, die elektrische Verbindung der Masseanschlüsse in einer großflächigen Masseebene vorzunehmen.

Trotz dieser vorteilhaften Anordnung können über die Masseanschlüsse einzelner Bauelemente abfließende starke Leistungsströme zu Potentialverschiebungen und zu erheblichen Stromdichten in der Masseebene führen. Ein gravierender Nachteil besteht nun darin, daß bei hohen Stromdichten in der Masseebene kleine analoge Signalspannungen mit nicht tolerierbaren Fehlern behaftet werden. Außerdem verursacht der Masseanschluß von analogen signalverarbeitenden und schnell arbeitenden digitalen Bauelementen an einer gemeinsamen Masseebene eine unerwünschte hochfrequente Kopplung, die vor allem über den Masseanschluß oder die Masseanschlüsse des Steuergerätes abgestrahlt wird.

Aus diesem Grund gibt es Lösungen, welche den schnell arbeitenden digitalen Bauelementen einerseits und den signalverarbeitenden Bauelementen andererseits voneinander isolierte Masseebenen zuordnen, wobei als signalverarbeitende Bauelemente ausschließlich analoge Bauelemente vorgesehen sind und die beiden isolierten Masseebenen jeweils getrennt voneinander mit einer dritten Masseebene über Leitungsverbindungen verbunden sind. Aus der EP 0 429 695 ist ein elektronisches Steuergerät, insbesondere zur Steuerung von Funktionen eines Kraftfahrzeuges gemäß der Gattung bekannt, welches für die schnell arbeitenden digitalen Bauelemente eine solche Ausgestaltung der Masseebene vorsieht, die bis auf eine leitende Verbindung mit einer gemeinsamen Massegrundplatte, die auch den Masseanschluß des Steuergerätes aufweist, von einer den signalverarbeitenden analogen Bauelementen zugeordneten Masseebene, die den Masseanschluß von Signal- und Schirmleitung aufweist, isoliert ist. Hierdurch wird erreicht, daß die hochfrequente Kopplung zwischen der den signalverarbeitenden analogen Bauelementen zugeordneten Masseebene und der den schnell arbeitenden digitalen Bauelementen zugeordneten Masseebene verringert wird, was sich wiederum positiv auf die Störabstrahlung über die Anschlußleitungen des Steuergerätes auswirkt.
Als nachteilig bei dieser Lösung muß jedoch angesehen werden, daß trotz der getrennten Ausführung der beiden Masseebenen, die von den Leistungsbauelementen erzeugten hohen Stromdichten und die von den schnell arbeitenden digitalen Bauelementen hervorgerufenen hochfrequenten Störströme sowohl über die Massegrundplatte abfließen und zu Potentialverschiebungen in der daran angeschlossenen analogen Masseebene führen, wodurch kleine Signale der mit der analogen Masseebene direkt verbundenen signalverarbeitenden analogen Bauelemente verfälscht werden können, als auch sehr große Stromschleifen durchlaufen, wodurch sie ihrerseits aufgrund ihrer Antennenwirkung wiederum die Störabstrahlung des Steuergerätes vergrößern.

### Vorteile der Erfindung

Durch die kennzeichnenden Merkmale des Patentanspruchs 1 wird die durch hochfrequente Störströme verursachte Störabstrahlung des Steuergerätes verringert und eine Beeinträchtigung der Signalverarbeitung durch hohe Stromdichten in der Masseebene, die auch von den Leistungsbauelementen hervorgerufen wird, vermieden. Dies wird erreicht, indem nur eine einzige großflächige Masseebene vorgesehen wird und zunächst nur die Masseanschlüsse der zum Bussystem gehörenden, schnell arbeitenden digitalen Bauelemente und die Masseanschlüsse der Leistungsbauelemente mit dieser Masseebene auf direktem Weg leitend verbunden werden. Unter einer Verbindung auf direktem Weg ist eine Verbindung zu verstehen, die ein Bauelement unter Berücksichtigung der Position anderer elektrischer Verbindungen und anderer Bauelemente auf dem möglichst kürzesten Weg mit der Anschlußstelle leitend verbindet, ohne daß ein drittes Bauelement zwischengeschaltet ist. Die schnell arbeitenden digitalen Bauelemente können im Unterschied zu den signalverarbeitenden Bauelementen auch über mehrere leitende Verbindungen mit der gemeinsamen Masseebene direkt verbunden sein, da die Störspannungen in der Masseebene die Funktionsweise der schnell arbeitenden digitalen Bauelemente nicht beeinträchtigen können. Durch die direkte Verbindung von schnell arbeitenden digitalen und Leistungsbauelementen mit der gemeinsamen Masseebene wird erreicht, daß die den Leistungsbauelementen zugeführten hochfrequenten Signale der schnell arbeitenden digitalen Bauelemente auf der Masseebene direkt unterhalb der Signalleitung zurückfließen, da gerade auf diesem Weg, auch wenn dies nicht der geometrisch kürzeste Weg zwischen den beiden Bauelementen sein sollte, die Impedanz am geringsten ist. Die Ströme brauchen keinen Umweg über eine zusätzliche Masseebene oder Masseleitung zu machen, wodurch die Induktivität der Masseverbindungen und die Stromschleifenflächen der Störströme, die als kleine Antennen wirkten, wesentlich verkleinert werden. Damit wird aber sowohl die Störabstrahlung und Einstrahlfestigkeit des Steuergerätes wesentlich verbessert als auch der Entstöraufwand weiter reduziert - so kann z.B. in vielen Fällen auf zusätzliche Steckerkondensatoren und Abschirmbleche verzichtet werden, wodurch sich die Herstellungskosten des Steuergerätes senken lassen.

Die signalverarbeitenden analogen und digitalen Bauelemente werden aber nicht einfach einzeln auf direktem Weg mit dieser Masseebene verbunden, da sonst deren Funktionsweise durch Potentialverschiebungen, die durch lokal unterschiedliche Stromdichten in der Masseebene hervorgerufen werden, oder durch die ungünstige Masseanbindung eines Filterbauelements oder durch zu große Stromschleifenflächen gefährdet würde und durch eingekoppelte starke Störsignale sogar die Funktionsweise der signalverarbeitenden digitalen Bauelemente beeinträchtigt werden könnte. Statt dessen werden die signalverarbeitenden analogen und digitalen Bauelemente, die wenigstens eine gemeinsame Funktion besitzen, in Funktionsbaugruppen zusammengefaßt und die Masseanschlüsse aller Bauelemente jeweils einer solchen Funktionsbaugruppe über Leitungsverbindungen mit einer gemeinsamen Verbindungsstelle (Massebezugspunkt) verbunden. Erst diese Verbindungsstelle jeweils einer Funktionsbaugruppe ist auf kürzestem Wege mit der gemeinsamen Masseebene verbunden. Hierdurch wird erreicht, daß alle Bauelemente, die zu einer signalverarbeitenden Funktionsbaugruppe gehören, nur über eine Verbindungsstelle mit der Masseebene verbunden sind. Der Störstrom eines schnell arbeitenden digitalen Bauelements, der durch Leistungsbauelemente noch vergrößert wird und über die Masseebene abgeleitet wird, kann nun lediglich das Potential an der allen Bauelementen einer signalverarbeitenden Funktionsbaugruppe gemeinsamen Verbindungsstelle verschieben, wodurch sich das Potential aller einzelnen Bauelemente der betreffenden Funktionsbaugruppe in gleichem Maße hebt oder senkt. Es entsteht also keine Potentialverschiebung zwischen den einzelnen Bauelementen der Funktionsbaugruppe, und eine Beeinträchtigung der Funktionsweise der Baugruppe durch den Störstrom wird vermieden.
Die Verbindungsstelle jeweils einer Funktionsbaugruppe weist nur eine einzige Verbindung mit der Masseebene, z.B. in Form einer einzigen Durchmetallisierung, auf. Nach Anspruch 3 ist es aber auch möglich, die Verbindungsstelle mit mehreren, dicht beieinander liegenden Kontaktierungen zur gemeinsamen Masseebene auszugestalten. Entscheidend ist hierbei, daß die Kontaktierungen mit der Masseebene so eng beieinander liegen, daß die Kontaktstellen ein im wesentlichen übereinstimmendes Potential aufweisen und sich zwischen den Kontaktstellen mit der Masseebene keine die Funktionsweise der Baugruppe beeinträchtigende Potentialdifferenz einstellen kann. So ist es zum Beispiel denkbar, daß die Verbindungsstelle zwei nur wenige Millimeter voneinander entfernte Durchmetallisierungen aufweist.
Enthält eine signalverarbeitende Funktionsbaugruppe einen integrierten Schaltkreis (IC), so ist es vorteilhaft, die Verbindungsstelle der Funktionsbaugruppe in direkter Nähe zum Masseanschluß des IC anzuordnen und den Minusanschluß eines Stütz- oder Entkoppelkondensators in die Verbindungsstelle zu integrieren. Dies geschieht, indem der Masseanschluß des integierten Schaltkreises auf direktem Weg mit dem Minusanschluß des Kondensators verbunden wird, die restlichen Bauelemente der Funktionsbaugruppe ebenfalls mit dem Minusanschluß des Kondensators über Leitungsverbindungen verbunden werden und der Minusanschluß des Kondensators auf direktem Weg mit der gemeinsamen Masseebene verbunden wird.

Vorteilhafte Ausgestaltungen der Erfindung sind in den Unteransprüchen 2 bis 12, dem Nebenanspruch 13 und den Unteranspüchen 14 bis 23 angegeben. So wird z.B. durch die direkte Leitungsverbindung der Leistungsbaugruppen mit der gemeinsamen Masseebene nach Anspruch 4 erreicht, daß in der Masseebene keine zusätzlichen Aussparungen für die Leistungsmasse erforderlich sind, wodurch sich die hochfrequenten Spannungsdifferenzen in der Masseebene weiter reduzieren lassen.
Durch die Führung der Signalleitungs- und Masseleitungsverbindungen gemäß Anspruch 6 wird erreicht, daß Einstrahlungsschleifen möglichst klein gehalten werden, wobei ein Signalübersprechen vermieden werden kann, wenn in der Nähe der Position einer signalverarbeitenden Funktionsbaugruppe keine fremden, d.h. keine zu einer anderen Funktionsbaugruppe gehörenden Signalleitungen plaziert werden.
Wie im Unteranspruch 8 beschrieben, werden bei einem Bauelement mit einem schnell arbeitenden digitalen Funktionsteil und einem signalverarbeitenden analogen Funktionsteil, z.B. einem Mikrokontroller mit integriertem A/D-Wandler, die Anschlüsse des A/D-Wandlers wie die Anschlüsse einer unabhängigen signalverarbeitenden analogen Funktionsbaugruppe getrennt von den restlichen Anschlüssen des Kontrollers über eine dem signalverarbeitenden Funktionsteil zugeordnete Verbindungsstelle mit der Masseebene verbunden.

Die in den Unteransprüchen 9 bis 12 beschriebene Ausführung in Form einer Mehrlagenleiterplatte stellt eine besonders vorteilhafte Ausgestaltung des Baugruppenträgers dar. Die allen Masseanschlüssen der Bauelementen einer Funktionsbaugruppe gemeinsame Verbindungsstelle läßt sich durch die in der Leiterplattentechnik gebräuchlichen Durchmetallisierungen leicht realisieren, und die Masseleitungen können über mehrere Lagen der Leiterplatte mit der Durchmetallisierung verbunden werden, was den Gestaltungsfreiraum für die Anordnung der Bauelemente und Verbindungsleitungen erheblich vergrößert.

Die Erfindung wird durch den im Nebenanspruch 13 beschriebenen Erfindungsgedanken vorteilhaft weiterentwickelt. Durch die Einführung einer Spannunsversorgungsebene mit Spannungsversorgungsleitungen und einem leitenden Flächenstück wird erreicht, daß auch die Stromschleifenflächen und die galvanische Kopplung über die positive Spannungsversorgung einer signalverarbeitenden Funktionsbaugruppe reduziert werden, wobei die einzelnen Spannungsversorgungsanschlüsse der Bauelemente der Funktionsbaugruppe ebenso wie die Masseanschlüsse mit einer Verbindungsstelle verbunden werden, die wiederum mit einer in der Spannungsversorgungsebene verlaufenden Spannungsversorgungsleitung auf direktem Weg verbunden wird. Wie im Unteranspruch 17 beschrieben ist es vorteilhaft, ein schnell arbeitendes digitales Bauelement mit mehreren Spannungsversorgungsanschlüssen, z.B. einen Mikroprozessor, nicht direkt mit dem leitenden Flächenstück der Spannungsversorgungsebene zu verbinden, sondern jeden Spannungsversorgungsanschluß zunächst an den Plusanschluß eines in unmittelbarer Nähe zum Mikroprozessor plazierten Stütz- oder Entkoppelkondensatores anzubinden und diesen Plusanschluß dann auf direktem Weg mit dem leitenden Flächenstück zu verbinden. Um eine optimale Wirkung des Stütz- bzw. Entkoppelkondensators zu erreichen ist die Gesamtinduktivität zwischen den Mikroprozessoranschlüssen und den Kondensatoranschlüssen so klein wie möglich zu halten. Dies wird erreicht, indem einerseits der Stütz- bzw Entkoppelkondensator in direkter Nähe zum Spannungsversorgungsanschluß des Mikroprozessors positioniert und mit diesem möglichst kurz verbunden wird und andererseits der Masseanschluß des Mikroprozessors und der Minusanschluß des Kondensators jeweils auf direktem Weg mit der Masseebene verbunden werden.
Um die Störabstrahlung über die Anschlußleitungen des Steuergerätes zu reduzieren, ist es vorteilhaft, die Schirmleitung auf direktem Weg mit der gemeinsamen Masseebene zu verbinden. Die schnell arbeitenden digitalen Bauelememte sollten möglichst eng zusammen und weit vom Steuergerätestecker entfernt angeordnet werden.

### Zeichnung

Ein Ausführungsbeispiel der Erfindung ist in der Zeichnung dargestellt und wird in der nachfolgenden Beschreibung näher erläutert. Es zeigt
Fig. 1 den schematisierten Aufbau einer Mehrlagenleiterplatte mit Bauelementen, die mit einer gemeinsamen Masseebene und mit einer gemeinsamen Spannungsversorgungsebene leitend verbunden sind,
Fig. 2 schematisch den Störstromkreis zwischen einem schnell arbeitenden digitalen Bauelement und einem Leistungsbauelement,
Fig. 3 eine Ausführungsform einer Signalverarbeitungsbaugruppe,
Fig. 4 und 5 Ausführungsformen der Verbindungsstelle einer einen IC enthaltenden signalverarbeitenden Funktionsbaugruppe mit der gemeinsamen Masseebene,
Fig. 6 die gemeinsame Spannungsversorgungsebene.

### Beschreibung des Ausführungsbeispiels

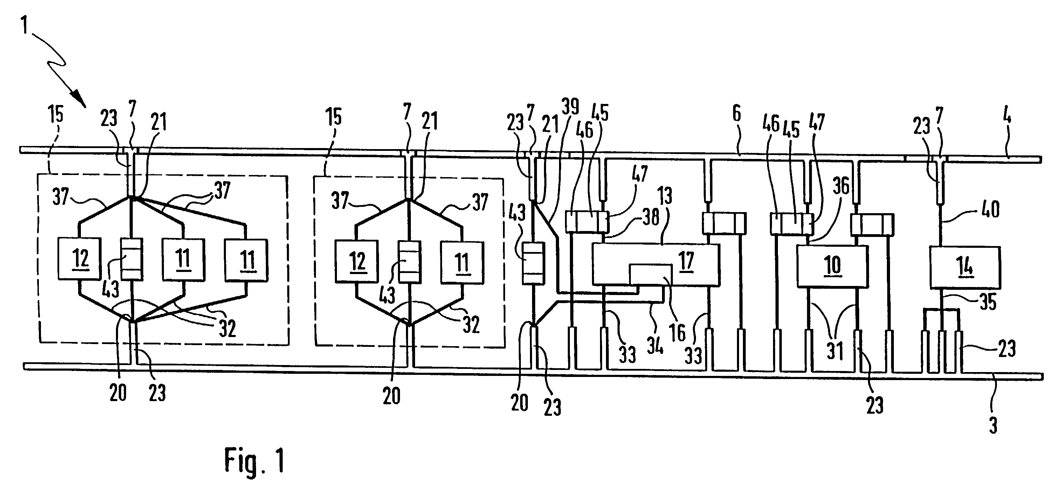

Wie in Fig. 1 dargestellt ist, umfaßt ein Baugruppenträger für ein elektronisches Steuergerät signalverarbeitende analoge Bauelemente 11, signalverarbeitende digitale Bauelemente 12, schnell arbeitende digitale Bauelemente 10 und Bauelemente 13 mit sowohl schnell arbeitenden digitalen Funktionsteilen 17 als auch signalverarbeitenden Funktionsteilen 16 sowie Leitungsbauelemente 14, die auf einem als Mehrlagenleiterplatte 1 ausgebildeten Baugruppenträger angeordnet sind. Die Anschlußkontakte für Signalleitung, Schirm und Masseleitung und die Verbindungsleitungen der Bauelemente untereinander sind in Fig. 1 nicht dargestellt. Die dargestellten Bauelemente können sich sowohl auf der als Komponentenseite bezeichneten Oberseite als auch auf der als Lötseite bezeichneten Unterseite des Baugruppenträgers befinden. Bei der Mehrlagenleiterplatte 1 ist eine einstückige, flächenhafte, gemeinsame Masseebene 3 vorgesehen, mit der alle Masseanschlüsse der Bauelemente elektrisch leitend verbunden sind, wobei als Masseverbindungen mit der Masseebene 3 senkrechte, durch die Mehrlagenleiterplatte 1 geführte, galvanische Verbindungen 23, wie zum Beispiel Durchmetallisierungen, vorgesehen sind.

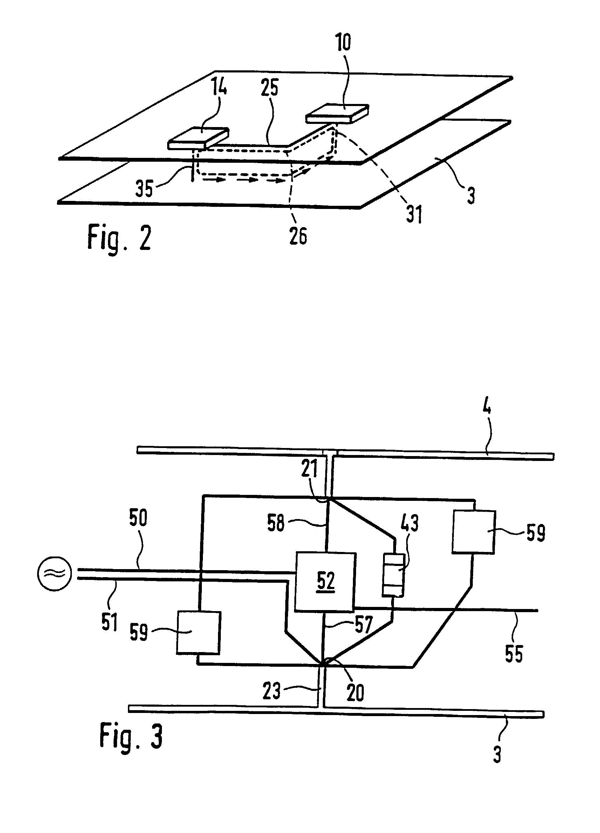

Die Masseanschlüsse der schnell arbeitenden digitalen Bauelemente 10 sind auf direktem Weg leitend mit der Masseebene 3 verbunden. Dabei können die schnell arbeitenden digitalen Bauelemente 10 auch über mehrere Verbindungen 31 mit der gemeinsamen Masseebene 3 elektrisch leitend verbunden sein. Die Leistungsbauelemente 14 sind ebenfalls auf direktem Weg über Verbindungen 35 mit der gemeinsamen Masseebene 3 leitend verbunden, dabei kann der Masseanschluß eines Leistungsbauelements auch über mehrere eng zusammenliegende Durchmetallisierungen 23 mit der gemeinsamen Masseebene verbunden sein. Ein von einem schnell arbeitenden digitalen Bauelement 10, wie z.B. einem ein Leistungsbauelement steuernden Mikroprozessor, erzeugter hochfrequenter Störstrom mit einer steilen Signalflanke, der über die Signalleitung 25 auf das Leistungsbauelement 14 übertragen und von diesem verstärkt wird, fließt auf der gemeinsamen Masseebene 3, wie aus Fig. 2 ersichtlich ist, direkt unterhalb der Signalleitung 25 ab, wodurch die Stromschleifenfläche 26 für den Störstrom sehr klein wird. Aufgrund ihrer geringen Ausdehnung wirken diese kleinen Störstromschleifen nur als kleine Antennen für das Aussenden von Störabstrahlung oder den Empfang von Störeinstrahlung. Es ist zweckmäßig die schnell arbeitenden digitalen Bauelemente in einem Bereich anzuordnen, der auf dem Baugruppenträger weiter entfernt von den signalverarbeitenden Funktionsbaugruppen und dem Steuergerätestecker angeordnet ist, um die hochfrequente Kopplung noch weiter zu verringern.

Wie in Fig.1 dargestellt, sind die signalverarbeitenden analogen Bauelemente 11 und die signalverarbeitenden digitalen Bauelemente 12 mit mindestens einer gemeinsamen Funktion zu signalverarbeitenden Funktionsbaugruppen 15 zusammengefaßt, wobei die Masseanschlüsse der Bauelemente jeweils einer Funktionsbaugruppe über Leitungsverbindungen 32 zu einer gemeinsamen Verbindungsstelle 20 geführt sind, die auf direktem Weg 23 mit der gemeinsamen Masseebene 3 leitend verbunden ist und zugleich die Verbindungsstelle eines Stütz- oder Entkoppelkondensators 43 ist. Die Leitungsverbindungen 32 der Bauelemente und des Kondensators 43 können dabei über eine oder auch mehrere Lagen der Mehrlagenleiterplatte mit der Verbindungsstelle 20 der Funktionsbaugruppe verbunden sein. Durch die gemeinsame Verbindungsstelle 20 liegt an allen Masseanschlüssen der Bauelemente einer signalverarbeitenden Funktionsbaugruppe 15 das gleiche elektrische Potential an, so daß der hochfrequente Störstrom eines schnell arbeitenden digitalen Bauelements 10, der über die gemeinsame Masseebene 3 abgeführt wird, über die Durchmetallisierung 23 der Verbindungstelle 20 und die Leitungsverbindungen 32 das Massepotential aller zur gleichen Funktionsbaugruppe gehörenden Bauelemente in gleichem Maße hebt und senkt, ohne daß es zu einer Potentialverschiebung zwischen den Bauelementen einer Funktionsbaugruppe kommt. Auf diese Weise wird durch die Einführung einer allen Bauelementen einer Funktionsbaugruppe gemeinsamen Verbindungstelle 20 erreicht, daß die Signalübertragung der Funktionsbaugruppe durch den Störstrom nicht mehr beeinträchtigt wird. Alternativ zu der hier gezeigten Ausführung ist es auch möglich, die Verbindungsstelle über mehrere dicht beieinander liegende Durchmetallisierungen mit der gemeinsamen Masseebene 3 zu verbinden. Dabei ist entscheidend, daß die Kontaktstellen der Durchmetallisierungen mit der Masseebene so dicht zusammenliegen, daß zwischen den Kontaktstellen keine die Funktionsweise der Baugruppe beeinträchtigende Potentialdifferenz auftreten kann.

Fig. 3 zeigt eine Ausführungsform einer Signalverarbeitungsbaugruppe. Über die Signalleitung 50 wird ein analoges Signal mit einer kleinen Spannung auf das Bauelement 52 übertragen und von diesem in ein digitales Signal, welches über die Signalausgangsleitung 55 abgeführt wird, übersetzt. Zwischen Spannungsversorgungsanschluß 58 und Masseanschluß 57 des Bauelements 52 ist ein Stütz- oder Entkoppelkondensator 43 angeschlossen. Die Masseleitungsverbindung 51 des Signalspannungsgebers verläuft zur Vermeidung von Einstrahlungsschleifen möglichst dicht neben der das Signal führenden Signalleitung 50 und ist mit dem Masseanschluß 57 des Bauelementes 52 an der Verbindungsstelle 20 zusammen mit dem Stütz- oder Entkoppelkondensator 43 angeschlossen. An der Verbindungsstelle 20 sind alle weiteren lokalen Massen 59 der Signalverarbeitungsbaugruppe angeschlossen. Die Verbindungsstelle 20 ist auf direktem Weg über eine Durchmetallisierung 23 mit der gemeinsamen Masseebene 3 des Steuergerätes leitend verbunden. Wie aus Fig. 3 ersichtlich ist, liegen alle Masseanschlüsse der Signalverarbeitungsbaugruppe über die Verbindungsstelle 20 auf gleichem Potential.

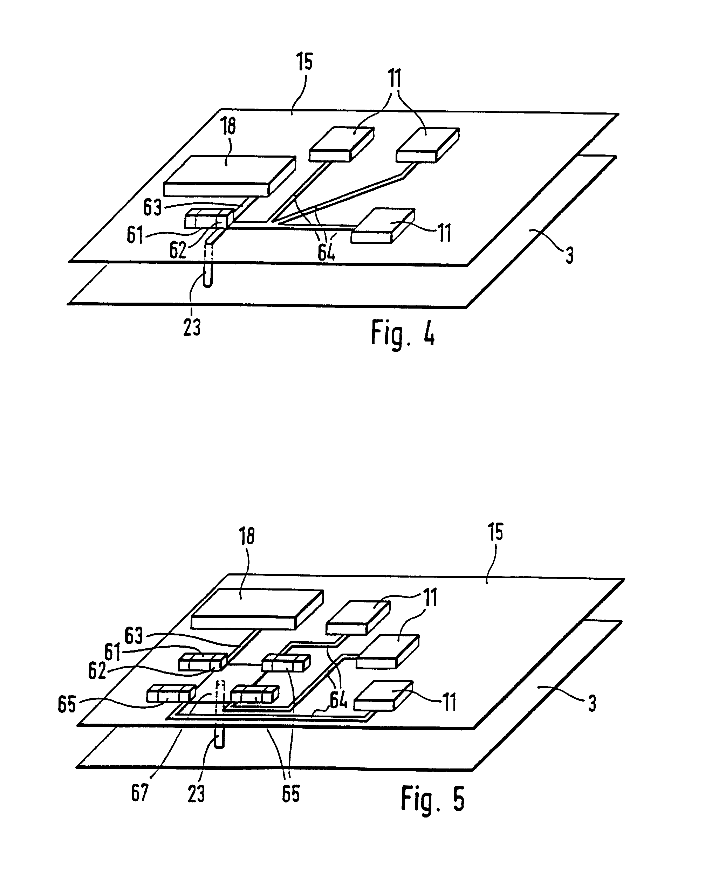

Enthält, wie in Fig. 4 dargestellt, eine signalverarbeitende Funktionsbaugruppe 15 einen integrierten Schaltkreis (IC) 18, so wird die Verbindungsstelle der Funktionsbaugruppe 15 in direkter Nähe zum Masseanschluß des IC's 18 angeordnet. Wie in Fig. 4 gezeigt ist, umfaßt die Verbindungsstelle den Minusanschluß 62 eines Stütz- oder Entkoppelkondensators 61, der auf direktem Weg über eine induktionsarme Verbindung 63 mit dem Masseanschluß des IC's verbunden ist. Der in die Verbindungsstelle integrierte Minusanschluß 62 des Kondensators 61 ist über eine Durchmetallisierung 23 mit der gemeinsamen Masseebene 3 verbunden. Die restlichen signalverarbeitenden Bauelemente 11 der Funktionsbaugruppe werden ebenfalls mit dem Minusanschluß 62 des Kondensators über Leitungsverbindungen 64 verbunden. Alternativ zu der hier dargestellten Ausführung der Verbindungsstelle ist es auch möglich, die Durchmetallisierung 23 direkt unter dem Minusanschluß 62 des Kondensators 61 anzubringen. Eine weitere Ausführungsform der Verbindungsstelle ist in Fig. 5 dargestellt. Der Masseanschluß des IC's ist mit dem Minusanschluß 62 eines Stütz- oder Entkoppelkondensators 61 über eine Verbindung 63 induktionsarm verbunden. Dieser ist wiederum flächig mit den Minusanschlüssen von drei Eingangsfilterkondensatoren 65 des IC's verbunden. Die in die Verbindungsstelle integrierte Durchmetallisierung 23 befindet sich in der Mitte unterhalb der flächigen Verbindung 67 der Kondensatoren. Die Masseanschlüsse der anderen signalverarbeitenden Bauelemente 11 der Funktionsbaugruppe 15 sind über Leitungsverbindungen 64 mit der flächigen Verbindung 67 leitend verbunden.

Besteht ein Bauelement 13 aus einem sowohl signalverarbeitenden Funktionsteil 16 als auch einem schnell arbeitenden digitalen Funktionsteil 17, z.B. aus einem Mikrokontroller mit eingebautem A/D-Wandler, so wird wie in Fig. 1 dargestellt, der Masseanschluß 34 des signalverarbeitenden Funktionsteils 16 wie der Masseanschluß einer unabhängigen signalverarbeitenden Funktionsbaugruppe behandelt und getrennt von den anderen Masseanschlüssen 33 des Bauelements über eine Verbindungsstelle 20 mit der gemeinsamen Masseebene 3 verbunden. Die Masseanschlüsse 33 des schnell arbeitenden digitalen Funktionsteils 17 werden wie die Masseanschlüsse 31 eines schnellen digitalen Bauelementes 10 einzeln auf direktem Weg mit der gemeinsamen Masseebene 3 verbunden.

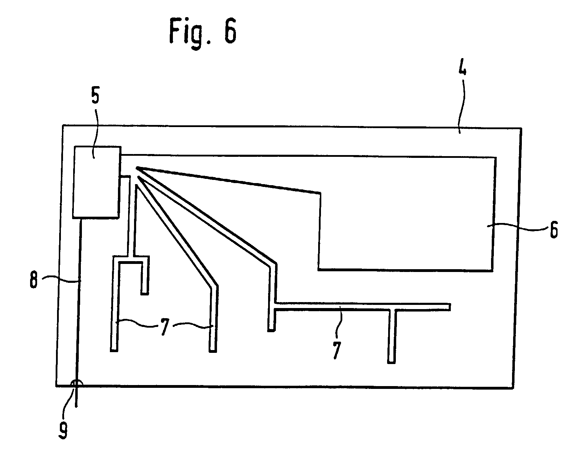

Fig. 1 zeigt eine Ausführungsform des Baugruppenträgers, bei der außer einer gemeinsamen großflächigen Masseebene 3 auch noch eine Spannungsversorgungsebene 4 vorgesehen ist. Wie in Fig. 6 gezeigt ist, besteht die Spannungsversorgungsebene 4 aus einzelnen Spannungsversorgungsleitungen 7 und einem Flächenstück 6, die an einen gemeinsamen Spannungsstabilisator 5 angeschlossen sind. Der Spannungsstabilisator 5 ist über eine weitere Leitung 8 mit dem Gerätestecker 9 verbunden. Die Leistungsbauelemente 14 sind auf direktem Weg über Verbindungen 40 mit Spannungsversorgungsleitungen 7 der Spannungsversorgungsebene 4 leitend verbunden. Das leitende Flächenstück 6 der Spannungsversorgungsebene 4 befindet sich auf der Mehrlagenleiterplatte 1 direkt oberhalb oder unterhalb der schnell arbeitenden digitalen Bauelemente 10 und der schnell arbeitenden digitalen Funktionsteile 17 der gemischten Bauelemente 13. Die Spannungsversorgungsanschlüsse 36 der schnell arbeitenden digitalen Bauelemente 10 sind mit dem Plusanschluß 47 eines in unmittelbarer Nähe zum Bauelement 10 plazierten Stütz- oder Entkoppelkondesators 45 verbunden. Die Verbindung 36 zwischen dem Spannungsversorgungsanschluß des Bauelementes 10 und dem Plusanschluß 47 des Kondensators ist möglichst kurz und flächig, um die Gesamtinduktivität so klein wie möglich zu halten. Erst der Plusanschluß 47 des Kondensators 45 ist auf direktem Weg mit dem leitenden Flächenstück 6 der Spannungsversorgungsebene 4 verbunden. Der Minusanschluß 46 des Kondensators 45 und der Masseanschluß des schnell arbeitenden digitalen Bauelementes ist jeweils auf direktem Weg mit der gemeinsamen Masseebene 3 verbunden. Wie die Masseanschlüsse können die schnell arbeitenden digitalen Bauelemente über mehrere Verbindungen 36 mit dem Flächenstück 6 der Spannungsversorgungsebene 4 leitend verbunden sein. Auf die gleiche Art sind die Spannungsversorgungsanschlüsse 38 der Bauelemente 13, die über einen schnell arbeitenden digitalen Funktionsteil 17 verfügen, mit der Spannungsversorgungsebene 4 verbunden.

Die zu einer signalverarbeitenden Funktionsbaugruppen 15 zusammengefaßten Bauelemente 11 und 12 werden über Leitungsverbindungen 37 zu einer gemeinsamen Verbindungsstelle 21 geführt, die auf direktem Weg mit Spannungsversorgungsleitungen 7 der gemeinsamen Spannungsversorgungsebene 4 leitend verbunden ist. Die Verbindungsstelle 21 ist auch die Verbindungsstelle des Stütz- oder Entkoppelkondensators 43 mit der Spannungsversorgungsebene. Die Leitungsverbindungen 37 können auch über mehrere Lagen der Mehrlagenleiterplatte mit der Durchmetallisierung der Verbindungstelle 21 der Funktionsbaugruppe verbunden sein. Der Spannungsversorgungsanschluß 39 des signalverarbeitenden Funktionsteils 16 eines gemischten Bauelementes 13 wird wie der Anschluß einer signalverarbeitenden Baugruppe mit einer Spannungsversorgungsleitung 7 der Spannungsversorgungsebene 4 verbunden.

## Patentansprüche

1. Baugruppenträger für ein elektronisches Steuergerät mit signalverarbeitenden Bauelementen und schnell arbeitenden digitalen Bauelementen, die elektrisch leitend mit einer gemeinsamen Masseebene verbunden sind, wobei die signalverarbeitenden Bauelemente jeweils einer Baugruppe eine gemeinsame Verbindung zur gemeinsamen Masseebene haben,
**dadurch gekennzeichnet**,
daß die signalverarbeitenden Bauelemente aus analogen Bauelementen (11) und/oder digitalen Bauelementen (12) bestehen und in Baugruppen (15) mit mindestens einer gemeinsamen Funktion, d.h. Funktionsbaugruppen, zusammengefaßt sind, deren gemeinsame Verbindung zur gemeinsamen Masseebene (3) zusammengefaßt jeweils über eine Verbindungsstelle (20) erfolgt, und die schnell arbeitenden digitalen Bauelemente (10) jeweils einzeln auf direktem Weg mit der gemeinsamen Masseebene (3) verbunden sind.

2. Baugruppenträger für ein elektronisches Steuergerät nach Anspruch 1, **dadurch gekennzeichnet**, daß die schnell arbeitenden digitalen Bauelemente mit einer Arbeitsfrequenz arbeiten, die spezifisch für die Datenübertragungsfrequenz von Datenbussen von datenverarbeitenden Baugruppen ist.

3. Baugruppenträger für ein elektronisches Steuergerät nach Anspruch 1 oder 2, **dadurch gekennzeichnet**, daß die Verbindungsstelle (20) eine einzige Verbindung ist oder eine aus mehreren Kontaktierungen bestehende, zu Stellen mit im wesentlichen übereinstimmenden Potential der Masseebene (3) führende Verbindung ist.

4. Baugruppenträger für ein elektronisches Steuergerät nach einem der Ansprüche 1 bis 3, **dadurch gekennzeichnet**, daß Leistungsbauelemente (14), ebenfalls auf direktem Weg mit der gemeinsamen Masseebene (3) verbunden sind.

5. Baugruppenträger für ein elektronisches Steuergerät nach einem der Ansprüche 1 bis 4, **dadurch gekennzeichnet**, daß die Verbindungsstelle (20) zugleich die kürzeste Verbindung eines Stütz- oder Entkoppelkondensators (43) zur Masse ist.

6. Baugruppenträger für ein elektronisches Steuergerät nach einem der Ansprüche 1 bis 5, **dadurch gekennzeichnet**, daß die Verbindungen der signalverarbeitenden Bauelemente (52) untereinander, bestehend aus einer Signalleitungsverbindung (50) und einer Masseleitungsverbindung (51), so gestaltet sind, daß die Signal- und Masseleitungsverbindung zur Vermeidung von Einstrahlungsschleifen möglichst dicht nebeneinander verlaufen.

7. Baugruppenträger für ein elektronisches Steuergerät nach Anspruch 1 bis 4, **dadurch gekennzeichnet**, daß die schnell arbeitenden digitalen Bauelemente (10), insbesondere Prozessoren und hochfrequent mit steilen Signalflanken arbeitende Bauelemente, jeweils über mehrere Masseanschlüsse (31) auf direktem Weg mit der gemeinsamen Masseebene (3) verbunden sind.

8. Baugruppenträger für ein elektronisches Steuergerät nach einem der Ansprüche 1 bis 7, **dadurch gekennzeichnet**, daß die Masseverbindung von Bauelementen (13) die sowohl schnell arbeitende digitale Funktionsteile (17) als auch signalverarbeitende digitale und/oder analoge Funktionsteile (16) haben mit der Masseebene (3) bei den Masseanschlüssen (33) für die schnell arbeitenden digitalen Funktionsteile (17) auf direktem Weg und bei den Masseanschlüssen (34) für die signalverarbeitenden Funktionsteile (16) über die Verbindungsstelle (20) erfolgt.

9. Baugruppenträger für ein elektronisches Steuergerät nach einem der Ansprüche 1 bis 8, **dadurch gekennzeichnet**, daß der Baugruppenträger als Mehrlagenleiterplatte (1) ausgeführt ist, bei der die elektrische Verbindung der einzelnen Bauelemente in mehreren übereinander angeordneten Lagen von Leiteranordnungen oder Leiterbahnen erfolgt, wobei eine dieser Lagen als großflächige Masseebene (3) ausgestaltet ist.

10. Baugruppenträger für ein elektronisches Steuergerät nach Anspruch 9, **dadurch gekennzeichnet**, daß bei den schnell arbeitenden digitalen Bauelementen (10) und den Leistungsbauelementen (14) die Verbindung der einzelnen Masseanschlüsse mit der gemeinsamen Masseebene (3) über senkrecht zur Mehrlagenleiterplatte (1) verlaufende, elektrische Verbindungen (23) erfolgt.

11. Baugruppenträger für ein elektronisches Steuergerät nach Anspruch 10, **dadurch gekennzeichnet**, daß die Verbindungsstelle (20) der in jeweils einer Funktionsbaugruppe (15) zusammengefaßten signalverarbeitenden Bauelemente eine senkrecht zur Mehrlagenleiterplatte (1) verlaufende, elektrische Verbindung (23) mit der gemeinsamen Masseebene (3) aufweist, wobei die Masseleitungen (37) der Bauelemente über eine oder mehrere Lagen der Mehrlagenleiterplatte (1) bis zum Anschluß an die senkrechte elektrische Verbindung (23) geführt sind.

12. Baugruppenträger für ein elektronisches Steuergerät nach Anspruch 10 oder 11, **dadurch gekennzeichnet**, daß die senkrecht zur Mehrlagenleiterplatte (1) verlaufenden, elektrischen Verbindungen (23) Durchmetallisierungen sind.

13. Baugruppenträger für ein elektronisches Steuergerät mit signalverarbeitenden und schnell arbeitenden digitalen Bauelementen, die elektrisch leitend mit einer gemeinsamen Masseebene verbunden sind, wobei die signalverarbeitenden Bauelemente jeweils einer Baugruppe eine gemeinsame Verbindung zur gemeinsamen Masseebene haben,
**dadurch gekennzeichnet**,
daß die signalverarbeitenden Bauelemente aus analogen Bauelementen (11) und/oder digitalen Bauelementen (12) bestehen und in Baugruppen (15) mit mindestens einer gemeinsamen Funktion (Funktionsbaugruppen) zusammengefaßt sind, deren gemeinsame Verbindung zur gemeinsamen Masseebene (3) zusammengefaßt jeweils über eine Verbindungsstelle (20) erfolgt, und die schnell arbeitenden digitalen Bauelemente (10) jeweils einzeln auf direktem Weg mit der gemeinsamen Masseebene (3) verbunden sind und daß eine Spannungsversorgungsebene (4) mit Spannungsversorgungsleitungen (7) und mindestens einem leitenden Flächenstück (6) vorgesehen ist und die signalverarbeitenden und schnell arbeitenden digitalen Bauelemente leitend mit der Spannungsversorgungsebene (4) derart verbunden sind, daß die signalverarbeitenden Bauelemente (11,12) jeweils einer Funktionsbaugruppe (15) zusammengefaßt über eine Verbindungsstelle (21) mit einer in der Spannungsversorgungsebene (4) verlaufenden Spannungsversorgungsleitung (7) verbunden sind und die schnell arbeitenden digitalen Bauelemente (10) jeweils einzeln mit dem leitenden Flächenstück (6) verbunden sind.

14. Baugruppenträger für ein elektronisches Steuergerät nach Anspruch 13, **dadurch gekennzeichnet**, daß
Leistungsbauelemente (14), ebenfalls mit Spannungsversorgungsleitungen (7) der Spannungsversorgungsebene (4) und auf direktem Weg mit der gemeinsamen Masseebene (3) verbunden sind.

15. Baugruppenträger für ein elektronisches Steuergerät nach Anspruch 13 oder 14, **dadurch gekennzeichnet**, daß die Verbindungsstelle (21) zur Spannungsversorgungsebene zugleich die kürzeste Verbindung eines Stütz- oder Entkoppelkondensators (43) zur Spannungsversorgungsebene ist und die Verbindungsstelle (20) zur gemeinsamen Masseebene (3) ebenfalls zugleich die kürzeste Verbindung des Stütz- oder Entkoppelkondensators (43) zur Masse ist.

16. Baugruppenträger für ein elektronisches Steuergerät nach einem der Ansprüche 13 bis 15, **dadurch gekennzeichnet**, daß die Verbindungen der signalverarbeitenden Bauelemente (52) untereinander, bestehend aus einer Signalleitungsverbindung (50) und einer Masseleitungsverbindung (51), so gestaltet sind, daß die Signal- und Masseleitungsverbindung zur Vermeidung von Einstrahlungsschleifen möglichst dicht nebeneinander verlaufen.

17. Baugruppenträger für ein elektronisches Steuergerät nach Anspruch 14, **dadurch gekennzeichnet**, daß jeder Spannungsversorgungsanschluß (36) eines schnell arbeitenden digitalen Bauelementes (10), insbesondere eines Prozessors und hochfrequent mit steilen Signalflanken arbeitenden Bauelementes, mit dem Plusanschluß (47) jeweils eines in unmittelbarer Nähe zum Spannungsversorgungsanschluß plazierten Stütz- bzw. Entkoppelkondensators (45) verbunden ist und der Plusanschluß (47) des Stütz- oder Entkoppelkondensators auf direktem Weg mit dem leitenden Flächenstück (6) der Spannungversorgungsebene verbunden ist und jeder Masseanschluß (31) auf direktem Weg mit der Masseebene (3) verbunden ist.

18. Baugruppenträger für ein elektronisches Steuergerät nach einem der Ansprüche 13 bis 17, **dadurch gekennzeichnet**, daß die Spannungsversorgungsverbindung der Bauelemente (13) die sowohl schnell arbeitende digitale Funktionsteile (17) als auch signalverarbeitende analoge und/oder digitale Funktionsteile (16) aufweisen bei den Anschlüssen (38) für die schnell arbeitenden digitalen Funktionsteile (17) mit der leitenden Fläche (6) der Spannungsversorgungsebene (4) und bei den Anschlüssen (39) für die signalverarbeitenden Funktionsteile (16) über die Verbindungsstelle (21) mit den Spannungsversorgungsleitungen (7) der Spannungsversorgungsebene (4) erfolgt und die Masseverbindung dieser Baugruppen mit der gemeinsamen Masseebene (3) bei den Anschlüssen (33) für die schnell arbeitenden digitalen Funktionsteile (17) auf direktem Weg und bei den Anschlüssen (34) für die signalverarbeitenden Funktionsteile (16) über die Verbindungsstelle (20) mit der Masseebene (3) erfolgt.

19. Baugruppenträger für ein elektronisches Steuergerät nach einem der Ansprüche 13 bis 18, **dadurch gekennzeichnet**, daß der Baugruppenträger als Mehrlagenleiterplatte (1) ausgeführt ist, bei der die elektrische Verbindung der einzelnen Bauelemente in mehreren übereinander angeordneten Lagen von Leiteranordnungen oder Leiterbahnen erfolgt, wobei eine dieser Lagen als großflächige Masseebene (3) und eine weitere Lage als Spannungsversorgungsebene (4) vorgesehen ist.

20. Baugruppenträger für ein elektronisches Steuergerät nach Anspruch 19, **dadurch gekennzeichnet**, daß bei den schnell arbeitenden digitalen Bauelementen (10) und den Leistungsbauelementen (14) die Verbindung der einzelnen Masseanschlüsse mit der gemeinsamen Masseebene (3) über senkrecht zur Mehrlagenleiterplatte (1) verlaufende, elektrische Verbindungen (23) erfolgt und die Verbindung der einzelnen Spannungsversorgungsanschlüsse mit der Spannungsversorgungsebene (4) ebenfalls über senkrecht zur Mehrlagenleiterplatte (1) verlaufende, elektrische Verbindungen (23) erfolgt.

21. Baugruppenträger für ein elektronisches Steuergerät nach Anspruch 19, **dadurch gekennzeichnet**, daß die Verbindungsstelle (20) mit der Masseebene (3) der in jeweils einer Funktionsbaugruppe (15) zusammengefaßten signalverarbeitenden Bauelemente eine senkrecht zur Mehrlagenleiterplatte verlaufende, elektrische Verbindung (23) mit der gemeinsamen Masseebene (3) aufweist, wobei die Masseleitungen (32) der Bauelemente über eine oder mehrere Lagen der Mehrlagenleiterplatte bis zum Anschluß an die senkrechte elektrische Verbindung (23) geführt sind, und die Verbindungsstelle (21) mit der Spannungsversorgungsebene (4) der in jeweils einer Funktionsbaugruppe (15) zusammengefaßten signalverarbeitenden Bauelemente eine senkrecht zur Mehrlagenleiterplatte (1) verlaufende, elektrische Verbindung (23) mit der Spannungsversorgungsebene (4) aufweist, wobei die Spannungsversorgungsleitungen (37) der Bauelemente über eine oder mehrere Lagen der Mehrlagenleiterplatte bis zum Anschluß an die senkrechte elektrische Verbindung (23) geführt sind.

22. Baugruppenträger für ein elektronisches Steuergerät nach der Anspruch 20, **dadurch gekennzeichnet**, daß die senkrecht zur Mehrlagenleiterplatte (1) verlaufenden, elektrischen Verbindungen (23) Durchmetallisierungen sind.

23. Baugruppenträger für ein elektronisches Steuergerät nach einem der Ansprüche 1 bis 12, **dadurch gekennzeichnet**, daß eine Schirmleitung einer zum Baugruppentäger führenden Signalleitung auf direktem Weg mit der Masseebene verbunden ist.

## Claims

1. Mounting rack for an electronic controller having signal-processing components and high-speed digital components, which are electrically conductively connected to a common earth plane, the signal-processing components of each assembly having a common connection for the common earth plane, characterized in that the signal-processing components comprise analogue components (11) and/or digital components (12) and are combined in assemblies (15) having at least one common function, that is to say functional assemblies, whose common connection for the common earth plane (3) is in each case made jointly via a connection point (20), and the high-speed digital components (10) are each connected individually by a direct path to the common earth plane (3).

2. Mounting rack for an electronic controller according to Claim 1, characterized in that the high-speed digital components operate at an operating frequency which is specific for the data transmission frequency of data buses of data-processing assemblies.

3. Mounting rack for an electronic controller according to Claim 1 or 2, characterized in that the connection point (20) is a single connection or a connection which comprises a plurality of contacts and leads to points with an essentially matching potential on the earth plane (3).

4. Mounting rack for an electronic controller according to one of Claims 1 to 3, characterized in that power components (14) are likewise connected by a direct path to the common earth plane (3).

5. Mounting rack for an electronic controller according to one of Claims 1 to 4, characterized in that the connection point (20) is at the same time the shortest connection between an energy-storage or decoupling capacitor (43) and earth.

6. Mounting rack for an electronic controller according to one of Claims 1 to 5, characterized in that the connections between the signal-processing components (52), comprising a signal line connection (50) and an earth line connection (51), are designed such that the signal line connection and the earth line connection are routed as close to one another as possible in order to avoid loops susceptible to radiated interference.

7. Mounting rack for an electronic controller according to Claims 1 to 4, characterized in that the high-speed digital components (10), in particular processors and components which operate at radio frequencies with steep signal flanks, are each connected via a plurality of earth connections (31) by a direct path to the common earth plane (3).

8. Mounting rack for an electronic controller according to one of Claims 1 to 7, characterized in that the earth connection from components (13) which have both high-speed digital functional parts (17) and signal-processing digital and/or analogue functional parts (16) to the earth plane (3) is made by a direct path in the case of the earth connections (33) for the high-speed digital functional parts (17) and via the connection point (20) in the case of the earth connections (34) for the signal-processing functional parts (16).

9. Mounting rack for an electronic controller according to one of Claims 1 to 8, characterized in that the mounting rack is designed as a multilayer printed circuit board (1) in which the electrical connection of the individual components is made in a plurality of layers (which are arranged one above the other) of conductor arrangements or conductor tracks, in which case one of these layers is designed as a large-area earth plane (3).

10. Mounting rack for an electronic controller according to Claim 9, characterized in that, in the case of the high-speed digital components (10) and the power components (14), the connection between the individual earth connections and the common earth plane (3) is made via electrical connections (23) which run at right angles to the multilayer printed circuit board (1).

11. Mounting rack for an electronic controller according to Claim 10, characterized in that the connection point (20) of those signal-processing components which are in each case combined in a functional assembly (15) has an electrical connection (23), which run at right angles to the multilayer printed circuit board (1), to the common earth plane (3), in which case the earth lines (37) of the components are routed via one or more layers of the multilayer printed circuit board (1) to the connection to the electrical connection (23) which is at right angles.

12. Mounting rack for an electronic controller according to Claim 10 or 11, characterized in that the electrical connections (23) which run at right angles to the multilayer printed circuit board (1) are through-plated holes.

13. Mounting rack for an electronic controller having signal-processing and high-speed digital components, which are electrically conductively connected to a common earth plane, the signal-processing components of each assembly having a common connection for the common earth plane, characterized in that the signal-processing components comprise analogue components (11) and/or digital components (12) and are combined in assemblies (15) having at least one common function (functional assemblies), whose common connection for the common earth plane (3) is in each case made jointly via a connection point (20), and the high-speed digital components (10) are each connected individually by a direct path to the common earth plane (3), and in that a voltage supply plane (4) having voltage supply lines (7) and at least one conductive area element (6) is provided, and the signal-processing and high-speed digital components are conductively connected to the voltage supply plane (4) in such a manner that the signal-processing components (11, 12) of each functional assembly (15) are jointly connected via a connection point (21) to a voltage supply line (7) which runs in the voltage supply plane (4), and the high-speed digital components (10) are each connected individually to the conductive area element (6).

14. Mounting rack for an electronic controller according to Claim 13, characterized in that power components (14) are likewise connected to voltage supply lines (7) in the voltage supply plane (4) and by a direct path to the common earth plane (3).

15. Mounting rack for an electronic controller according to Claim 13 or 14, characterized in that the connection point (21) for the voltage supply plane is at the same time the shortest connection between an energy-storage or decoupling capacitor (43) and the voltage supply plane, and the connection point (20) for the common earth plane (3) is likewise at the same time the shortest connection between the energy-storage or decoupling capacitor (43) and earth.

16. Mounting rack for an electronic controller according to one of Claims 13 to 15, characterized in that the connections between the signal-processing components (52), comprising a signal line connection (50) and an earth line connection (51), are designed such that the signal and earth line connections are routed as close to one another as possible in order to avoid loops susceptible to radiated interference.

17. Mounting rack for an electronic controller according to Claim 14, characterized in that each voltage supply connection (36) of a high-speed digital component (10), in particular of a processor and of a component which operates at radio frequencies with steep signal flanks, is connected to the positive connection (47) of in each case one energy-storage or decoupling capacitor (45) positioned in the immediate vicinity of the voltage supply connection, and the positive connection (47) of the energy-storage or decoupling capacitor is connected by a direct path to the conductive area element (6) on the voltage supply plane, and each earth connection (31) is connected by a direct path to the earth plane (3).

18. Mounting rack for an electronic controller according to one of Claims 13 to 17, characterized in that the voltage supply connection of the components (13) which have both high-speed digital functional parts (17) and signal-processing analogue and/or digital functional parts (16) is made to the conductive area (6) on the voltage supply plane (4) in the case of the connections (38) for the high-speed digital functional parts (17), and via the connection point (21) to the voltage supply lines (7) in the case of the connections (39) for the signal-processing functional parts (16), and the earth connection between these assemblies and the common earth plane (3) is made by a direct path in the case of the connections (33) for the high-speed digital functional parts (17), and via the connection point (20) to the earth plane (3) in the case of the connections (34) for the signal-processing functional parts (16).

19. Mounting rack for an electronic controller according to one of Claims 13 to 18, characterized in that the mounting rack is designed as a multilayer printed circuit board (1) in which the electrical connection of the individual components is made in a plurality of layers (which are arranged one above the other) of conductor arrangements or conductor tracks, in which case one of these layers is provided as a large-area earth plane (3), and a further layer is provided as the voltage supply plane (4).

20. Mounting rack for an electronic controller according to Claim 19, characterized in that, in the case of the high-speed digital components (10) and the power components (14), the connection between the individual earth connections and the common earth plane (3) is made via electrical connections (23) which run at right angles to the multilayer printed circuit board (1), and the connection between the individual voltage supply connections and the voltage supply plane (4) is likewise made via electrical connections (23) which run at right angles to the multilayer printed circuit board (1).

21. Mounting rack for an electronic controller according to Claim 19, characterized in that the connection point (20) to the earth plane (3) of the signal-processing components which are in each case combined in a functional assembly (15) has an electrical connection (23), which runs at right angles to the multilayer printed circuit board, to the common earth plane (3), in which case the earth lines (32) of the components are routed via one or more layers of the multilayer printed circuit board to the connection to the electrical connection (23) which is at right angles, and the connection point (21) to the voltage supply plane (4) of the signal-processing components which are in each case combined in a functional assembly (15) has an electrical connection (23), which runs at right angles to the multilayer printed circuit board (1), to the voltage supply plane (4), in which case the voltage supply lines (37) of the components are routed via one or more layers of the multilayer printed circuit board to the connection to the electrical connection (23) which is at right angles.

22. Mounting rack for an electronic controller according to Claim 20, characterized in that the electrical connections (23) which run at right angles to the multilayer printed circuit board (1) are through-plated holes.

23. Mounting rack for an electronic controller according to one of Claims 1 to 12, characterized in that a screen line of a signal line which leads to the mounting rack is connected by a direct path to the earth plane.

## Revendications

1. Support de blocs de composants pour un appareil de commande électronique comportant des composants de traitement de signal et des composants numériques rapides, reliés électriquement à un plan de masse commun, les composants de traitement de signal de chaque bloc ayant une liaison commune avec le plan de masse commun,
caractérisé en ce que
les composants de traitement de signal se composent de composants analogiques (11) et/ou de composants numériques (12) et sont réunis en blocs (15) ayant au moins une fonction commune, c'est-à-dire des blocs fonctionnels, dont la liaison commune est réunie au plan de masse commun (3) par respectivement un point de liaison (20), et les composants numériques rapides (10) sont reliés chaque fois par un chemin direct au plan de masse commun (3).

2. Support de blocs de composants pour un appareil de commande électronique selon la revendication 1,
caractérisé en ce que
les composants numériques rapides fonctionnent à une fréquence caractéristique de la fréquence de transmission de données sur des bus de données de blocs de traitement de données.

3. Support de blocs de composants pour un appareil de commande électronique selon la revendication 1 ou 2,
caractérisé en ce que
le point de jonction (20) est une liaison commune ou une liaison conduisant à plusieurs endroits à potentiel essentiellement concordant du plan de masse (3).

4. Support de blocs de composants pour un appareil de commande électronique selon l'une quelconque des revendications 1 à 3,
caractérisé en ce que
les composants de puissance (14) sont également reliés suivant un chemin direct au plan de masse commun (3).

5. Support de blocs de composants pour un appareil de commande électronique selon l'une quelconque des revendications 1 à 4,
caractérisé en ce que
le point de liaison (20) est en même temps la liaison la plus courte entre un condensateur de soutien ou de découplage (43) et la masse.

6. Support de blocs de composants pour un appareil de commande électronique selon l'une quelconque des revendications 1 à 5,
caractérisé en ce que
les liaisons des composants de traitement de signaux (52) entre eux, formées d'une liaison de lignes de signaux (50) et d'une liaison de lignes de masse (51), sont prévues pour que la liaison de la ligne de signaux et la ligne de masse soit aussi rapprochée que possible pour éviter les boucles de rayonnement induit.

7. Support de blocs de composants pour un appareil de commande électronique selon l'une quelconque des revendications 1 à 4,
caractérisé en ce que
les composants numériques rapides (10), notamment les processeurs et les composants haute fréquence à signaux à flanc raide, sont reliés chaque fois par plusieurs branchements de masse (31), selon un chemin direct, avec le plan de masse (3).

8. Support de blocs de composants pour un appareil de commande électronique selon l'une quelconque des revendications 1 à 7,
caractérisé en ce que
la liaison de masse des composants (13) qui ont à la fois la partie fonctionnelle numérique rapide (17) et la partie fonctionnelle numérique de traitement de signaux et/ou analogique (16), avec le plan de masse (3), se fait pour les branchements de masse (33) de la partie fonctionnelle numérique rapide (17), de manière directe, et pour les branchements de masse (33) pour la partie fonctionnelle de traitement de signaux (16), par le point de liaison (20).

9. Support de blocs de composants pour un appareil de commande électronique selon l'une quelconque des revendications 1 à 8,
caractérisé en ce que
le support de blocs est réalisé sous la forme d'une plaque de circuit à plusieurs couches (1), dans laquelle la liaison électrique des différents composants se fait dans plusieurs couches superposées de dispositifs conducteurs ou de chemins conducteurs, l'une des couches étant réalisée sous la forme d'un plan de masse de grande surface (3).

10. Support de blocs de composants pour un appareil de commande électronique selon la revendication 9,
caractérisé en ce que
pour des composants numériques rapides (10) et des composants de puissance (14), la liaison des différents branchements de masse avec le plan de masse commun (3) se fait par des liaisons électriques (23) perpendiculaires à la plaque de circuit à plusieurs couches (1).

11. Support de blocs de composants pour un appareil de commande électronique selon la revendication 10,
caractérisé en ce que
le point de liaison (20) des composants de traitement de signaux réunis en un bloc fonctionnel (15), a une liaison électrique (23) perpendiculaire à la plaque de circuit à plusieurs couches (1), avec un plan de masse commun (3), les lignes de masse (37) des composants passant par une ou plusieurs couches de la plaque de circuit à plusieurs couches (1) jusqu'aux branchements à la liaison électrique perpendiculaire (23).

12. Support de blocs de composants pour un appareil de commande électronique selon l'une des revendications 10 ou 11,
caractérisé en ce que
les liaisons électriques (23) perpendiculaires à la plaque de circuit à plusieurs couches (1) sont des métallisations traversantes.

13. Support de blocs de composants pour un appareil de commande électronique comportant des composants de traitement de signaux et des composants numériques rapides, reliés électriquement à un plan de masse commun,
les composants de traitement de signaux de chaque bloc ayant une liaison commune avec le plan de masse commun,
caractérisé en ce que
- les composants de traitement de signaux comprennent des composants analogiques (11) et/ou des composants numériques (12) et sont regroupés en blocs (15) ayant au moins une fonction commune (blocs fonctionnels) dont la liaison commune avec le plan de masse commune se fait de façon réunie par un point de liaison (20), et les composants numériques rapides (10) sont respectivement reliés par un chemin direct au plan de masse commun (3), et
- un plan d'alimentation en tension (4) est prévu avec des lignes d'alimentation en tension (7) et au moins un élément de surface conducteur (6), et
- les composants de traitement de signaux et les composants numériques rapides sont reliés électriquement au plan d'alimentation en tension (4) pour que les composants de traitement de signaux (11, 12) de chaque bloc fonctionnel (15) soient réunis par un point de liaison (21) à une ligne d'alimentation en tension (7) passant dans le plan d'alimentation en tension (4), et les composants numériques rapides (10) sont chaque fois reliés séparément à l'élément de surface conducteur (6).

14. Support de blocs de composants pour un appareil de commande électronique selon la revendication 13,
caractérisé en ce que
les composants de puissance (14) sont également reliés aux lignes d'alimentation en tension (7) du plan d'alimentation en tension (4) et, par un chemin direct, au plan de masse commun (3).

15. Support de blocs de composants pour un appareil de commande électronique selon l'une des revendications 13 ou 14,
caractérisé en ce que
le point de liaison (21) avec le plan d'alimentation en tension est en même temps la liaison la plus courte d'un condensateur de soutien ou de découplage (41) avec le plan d'alimentation en tension, et le point de liaison (20) avec le plan de masse commun (3) est également en même temps la liaison la plus courte du condensateur de soutien ou de découplage (43) avec la masse.

16. Support de blocs de composants pour un appareil de commande électronique selon l'une des revendications 13 à 15,
caractérisé en ce que
les liaisons des composants de traitement de signaux (52) entre eux se composent d'une liaison de ligne de signaux (50) et d'une liaison de ligne de masse (51) conçues pour que la liaison par la ligne de signaux et celle par la ligne de masse soient aussi rapprochées que possible pour éviter des boucles de réception de rayonnement.

17. Support de blocs de composants pour un appareil de commande électronique selon la revendication 14,
caractérisé en ce que
chaque branchement de tension d'alimentation (36) d'un composant numérique rapide (10), notamment un processeur et un composant haute fréquence travaillant avec des signaux à flanc raide, est relié au branchement positif (47) d'un condensateur de soutien ou de découplage (45) respectif, situé à proximité immédiate du branchement d'alimentation en tension, et le branchement positif (47) du condensateur de soutien ou de découplage est relié par un chemin direct à l'élément de surface conducteur (6) du plan d'alimentation en tension, chaque branchement de masse (31) étant relié par un chemin direct au plan de masse (3).

18. Support de blocs de composants pour un appareil de commande électronique selon l'une des revendications 13 à 17,
caractérisé en ce que
la liaison d'alimentation en tension des composants (13) qui comportent à la fois des parties fonctionnelles numériques rapides (17) et des parties fonctionnelles analogiques et/ou numériques de traitement de signaux (16), a des branchements (38), pour les parties fonctionnelles numériques rapides (17), avec la surface conductrice (6) du plan d'alimentation en tension (4), et des branchements (39) pour les parties fonctionnelles de traitement de signal (16), par le point de liaison (21), avec les lignes d'alimentation en tension (7) du plan d'alimentation en tension (4), la liaison de masse de ces composants avec le plan de masse commun (3) se faisant, pour la partie fonctionnelle numérique rapide (17), suivant un chemin direct et, pour les branchements (34) des parties fonctionnelles de traitement de signaux (16), par le point de liaison (20) avec le plan de masse (3).

19. Support de blocs de composants pour un appareil de commande électronique selon l'une des revendications 13 à 18,
caractérisé en ce que
le support de blocs de composants est réalisé sous la forme d'une plaque de circuit à plusieurs couches (1) dont la liaison électrique des différents composants se fait dans plusieurs couches superposées de dispositifs conducteurs ou de chemins conducteurs, l'une des couches étant réalisée comme plan de masse de grande surface (3), et une autre couche comme plan d'alimentation en tension (4).

20. Support de blocs de composants pour un appareil de commande électronique selon la revendication 19,
caractérisé en ce que
pour des composants numériques rapides (10) et les éléments de puissance (14), la liaison des différents branchements de masse avec le plan de masse commun (3) se fait par des liaisons électriques (23) perpendiculaires à la plaque de circuit à plusieurs couches (1), et la liaison des différents branchements d'alimentation en tension avec le plan d'alimentation en tension (4) se fait également par des liaisons électriques (23) perpendiculaires à la plaque de circuit à plusieurs couches (1).

21. Support de blocs de composants pour un appareil de commande électronique selon la revendication 19,
caractérisé en ce que
- le point de liaison (20) avec le plan de masse (3) des composants de traitement de signaux regroupés en un bloc fonctionnel (15), comporte une liaison électrique (23) avec le plan de masse (3) commun, qui est perpendiculaire à la plaque de circuit à plusieurs couches,
- les lignes de masse (32) des composants étant conduites en une ou plusieurs couches de la plaque de circuit à plusieurs couches jusqu'au branchement à la liaison électrique perpendiculaire (23), et
- le point de liaison (21) avec le plan d'alimentation en tension (4) des composants de traitement de signaux chaque fois regroupés en un bloc fonctionnel (15), présente une liaison électrique (23) avec le plan d'alimentation en tension (4) également perpendiculaire à la plaque de circuit à plusieurs couches (1), les lignes d'alimentation en tension (37) des composants étant conduites par une ou plusieurs couches de la plaque à circuit à plusieurs couches jusqu'au branchement à la liaison électrique perpendiculaire (23).

22. Support de blocs de composants pour un appareil de commande électronique selon la revendication 20,
caractérisé en ce que
les liaisons électriques (23) perpendiculaires à la plaque de circuit à plusieurs couches (1) sont constituées par des métallisations traversantes.

23. Support de blocs de composants pour un appareil de commande électronique selon les revendications 1 à 12,
caractérisé en ce qu'
un blindage d'une ligne de signal conduisant à un support de blocs, est relié suivant un chemin direct au plan de masse.
